# EUROPEAN PATENT SPECIFICATION

(11) **EP 3 255 681 B1**
(45) Date of publication and mention of the grant of the patent: **27.03.2019**
(21) Application number: 17183715.6
(22) Date of filing: 21.06.2010
(51) Int. Cl.: H01L 31/048

(54) **MODULE LEVEL SOLUTION TO SOLAR CELL POLARIZATION USING AN ENCAPSULANT WITH OPENED UV TRANSMISSION CURVE**
LÖSUNG AUF MODULEBENE FÜR SOLARZELLENPOLARISATION MIT EINER VERKAPSELUNG MIT GEÖFFNETER UV-ÜBERTRAGUNGSKURVE
SOLUTION DE NIVEAU DE MODULE À POLARISATION DE CELLULE SOLAIRE AU MOYEN D'UN ENCAPSULANT À COURBE DE TRANSMISSION UV OUVERTE

(30) Priority: 27.08.2009 US 237588 P; 18.06.2010 US 818959
(43) Date of publication of application: 13.12.2017
(62) Divisional of application: 10812454.6
(73) Proprietor: SunPower Corporation, San Jose, CA 95134 (US)
(72) Inventor: BUNEA, Gabriela, Santa Clara, CA 95050 (US); BOITNOTT, Nicholas, Half Moon Bay, CA 94019 (US)
(74) Representative: Grünecker Patent- und Rechtsanwälte PartG mbB

(56) References cited:
- WO-A1-2005/006451
- WO-A1-2010/106000
- WO-A2-2008/036708
- JP-A- 2000 183 385
- JP-A- 2008 235 610

## Description

### BACKGROUND OF THE INVENTION

### 1. Field of the Invention

The present invention relates generally to solar cells, and more particularly but not exclusively to solar cell modules.

### 2. Description of the Background Art

Solar cells are well known devices for converting solar radiation to electrical energy. They may be fabricated on a semiconductor wafer using semiconductor processing technology. Generally speaking, a solar cell may be fabricated by forming p-type regions and n-type regions in a silicon substrate. Each adjacent p-type region and n-type region forms a p-n junction. Solar radiation impinging on the solar cell creates electrons and holes that migrate to the p-type and n-type regions, thereby creating voltage differentials across the p-n junctions. In a back junction solar cell, the p-type and n-type regions are formed on the backside along with the metal contacts that allow an external electrical circuit or device to be coupled to and be powered by the solar cell. Back junction solar cells are also disclosed in U.S. Patent Nos. 5,053,083 and 4,927,770. WO 2005/006451 A1 and JP 2000-183385 A describe the encapsulation of solar cells according to the prior art. WO 2010/106000 A1 published on 23 September 2010 and claiming priority dated on 18 March 2009 describes a photovoltaic module comprising plasticized intermediate layer films having high radiation transmission.

Several solar cells may be connected together to form a solar cell array. The solar cell array may be packaged into a solar cell module, which includes protection layers to allow the solar cell array to withstand environmental conditions and be used in the field.

If precautions are not taken, solar cells may become polarized in the field, causing reduced output power. Solutions to solar cell polarization are disclosed in U.S. Patent No. 7,554,031. The present disclosure pertains to a module-level solution to solar cell polarization using an improved encapsulant.

### SUMMARY

The subject matter of the present invention is defined in claim 1.

The preferred embodiments of the present invention are described in claims 2 to 7.

These and other features of the present invention will be readily apparent to persons of ordinary skill in the art upon reading the entirety of this disclosure, which includes the accompanying drawings and claims.

### DESCRIPTION OF THE DRAWINGS

FIG. 1 shows a solar cell module in accordance with an embodiment of the present invention.
FIG. 2 shows a cross-section of the solar cell module of FIG. 1 in accordance with an embodiment of the present invention.
FIG. 3 shows the transmission curves of glass and EVA used as encapsulant.
FIG. 4 shows the transmission curve of an encapsulant of a solar cell module in accordance with an embodiment of the present invention.
FIG. 5 shows results of an accelerated UV exposure test conducted on solar cell modules with an EVA encapsulant and with an encapsulant that has relatively wide UV transmission curve.
FIG. 6 shows plots of test data from an experiment comparing solar cell modules with encapsulant having a wide UV transmission curve versus a solar cell module with EVA encapsulant.
FIG. 7 shows field test results comparing output power of modules with an EVA encapsulant to modules made with an encapsulant that has wide UV transmission curve and high volume electrical resistance.
FIG. 8 shows the transmission curve of an encapsulant that may be employed in embodiments of the present invention.
FIGS. 9-11 show plots of test data comparing solar cell modules with a front protection package in accordance with an embodiment of the present invention and solar cell modules with glass transparent cover and EVA encapsulant.

The use of the same reference label in different drawings indicates the same or like components. The figures are not drawn to scale.

### DETAILED DESCRIPTION

In the present disclosure, numerous specific details are provided, such as examples of apparatus, components, and methods, to provide a thorough understanding of embodiments of the invention. Persons of ordinary skill in the art will recognize, however, that the invention can be practiced without one or more of the specific details. In other instances, well-known details are not shown or described to avoid obscuring aspects of the invention.

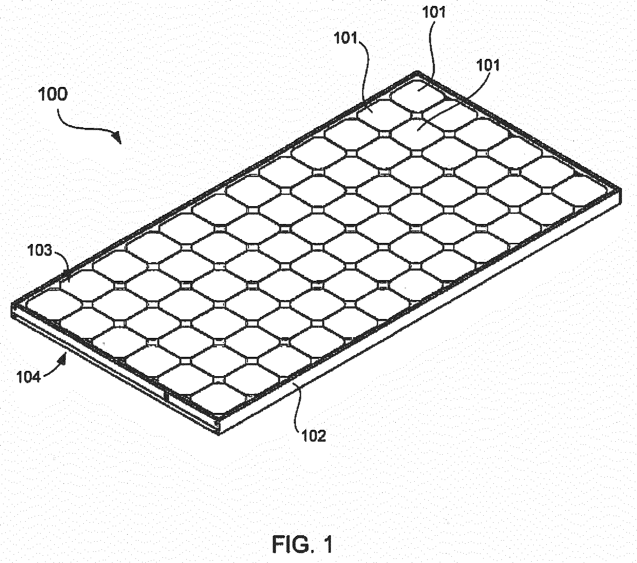

FIG. 1 shows a solar cell module 100 in accordance with an embodiment of the present invention. The solar cell module 100 is a so-called "terrestrial solar cell module" in that it is typically used in stationary applications, such as on rooftops or by power generating stations. In the example of FIG. 1, the solar cell module 100 includes an array of interconnected solar cells 101. Only some of the solar cells 101 are labeled in FIG. 1 for clarity of illustration. The solar cells 101 may comprise back junction solar cells, which are especially vulnerable to polarization. Visible in FIG. 1 are the front sides of the solar cells 101, which face the sun during normal operation. The backsides of the solar cells 101 are opposite the front sides. A frame 102 provides mechanical support for the solar cell array.

The front portion of the solar cell module 100, which is labeled as 103, is on the same side as the front sides of the solar cells 101 and is visible in FIG. 1. The back portion 104 of the solar cell module 100 is under the front portion 103. As will be more apparent below, the front portion 103 includes an optically transparent encapsulant.

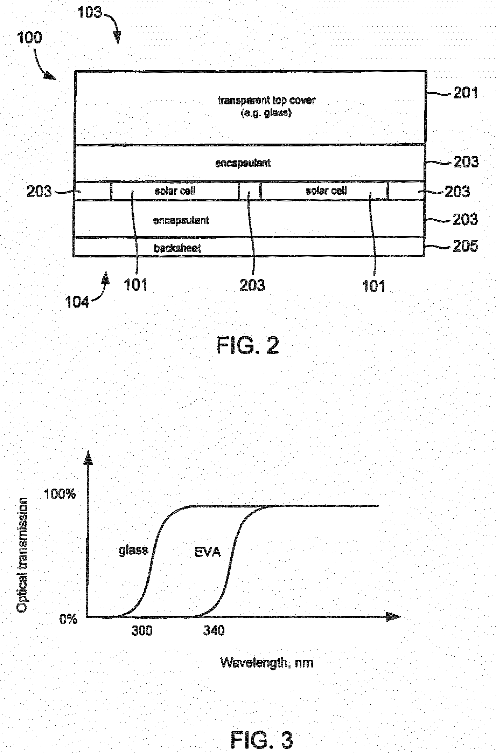

FIG. 2 shows a cross-section of the solar cell module 100 in accordance with an embodiment of the present invention. The solar cell module 100 includes a transparent cover 201, encapsulant 203, the solar cells 101, and a backsheet 205. The transparent cover 201, which is the topmost layer on the front portion 103, protects the solar cells 101 from the environment. The solar cell module 100 is installed such that the transparent cover 201 faces the sun during normal operation. The front sides of the solar cells 101 face towards the sun by way of the transparent cover 201. In the example of FIG. 2, the transparent cover 201 comprises glass (e.g., 3.2mm thick).

The backsides of the solar cells 101 face the backsheet 205, which is attached to the encapsulant 203. In one embodiment, the backsheet 205 comprises Tedlar/Polyester/EVA ("TPE") from the Madico company. In the TPE, the Tedlar is the outermost layer that protects against the environment, the polyester provides additional electrical isolation, and the EVA is a non-crosslinked thin layer that promotes adhesion to the encapsulant 203. Alternatives to TPE for use as the backsheet 205 include Tedlar/Polyester/Tedlar ("TPT"), for example. Other backsheets may also be used without detracting from the merits of the present invention.

The encapsulant 203 cures and bonds the solar cells 101, the transparent cover 201, and the backsheet 205 to form a protective package. As will be more apparent below, in one embodiment, the encapsulant 203 has an optimized UV (ultraviolet) transmission curve to allow more UV light to pass through. In one embodiment, the encapsulant 203 allows more UV light to pass through compared to conventional encapsulants.

Conventional solar cell modules use glass as the transparent cover and poly-ethyl-vinyl acetate ("EVA") as encapsulant. FIG. 3 shows the transmission curves of glass and EVA. Glass blocks light having a wavelength of about 275nm and shorter, while EVA blocks light having a wavelength of about 350 nm and shorter. For reference, UV light has a wavelength of 10nm to 400nm. Because UV is believed to degrade solar cells, solar cell modules are typically designed to have a relatively narrow UV transmission curve to limit exposure of solar cells to UV radiation. However, the inventor believes that the UV transmission curve can be opened up without substantial solar cell degradation. As can be appreciated by those of ordinary skill in the art, "block" does not necessarily mean complete blocking. As used in the present disclosure, "block" means a substantial reduction, including less than or equal to 1% transmission.

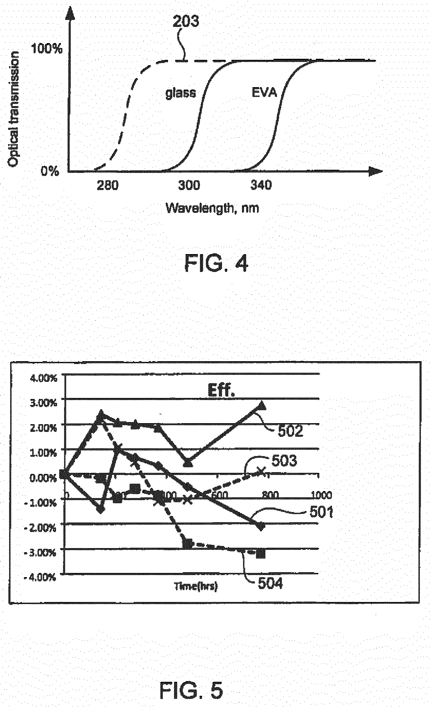

FIG. 5 shows results of an accelerated UV exposure test conducted on solar cell modules with an EVA encapsulant (plots 501 and 502) and with an encapsulant that has wide UV transmission curve (plots 503 and 504). The solar cells in the modules are back junction solar cells from Sunpower Corporation. FIG. 5 shows the resulting Efficiency ("Eff") test data versus time. Each day of the test simulates approximately 1/3 of one year of field use; the test simulates approximately the equivalent 11 years of UV exposure in the field. Plots 501 and 502 are test data from solar cell modules with EVA encapsulant, while plots 503 and 504 are test data from solar cell modules with an encapsulant that has wide UV transmission curve. As can be seen from the efficiency data of FIG. 5, use of encapsulant with wide UV transmission curve has no significant impact on the UV stability of the solar cell modules.

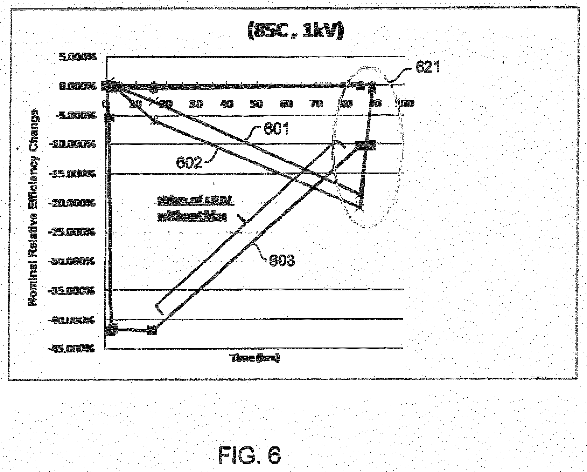

With a relatively wider UV transmission curve, the use of encapsulant 203 in the solar cell module 100 helps prevent the solar cells 101 from polarizing. FIG. 6 shows plots of test data from an experiment comparing solar cell modules with encapsulant having a wide UV transmission curve (plots 601 and 602) versus a solar cell module with EVA encapsulant (plot 603). The experiment was performed at 85 degrees Centigrade with a 1kV bias, and shows nominal relative efficiency change versus time. The loss in nominal relative efficiency is due to polarization. As can be seen from plots 601 and 602, the solar cell modules having an encapsulant with relatively wide UV transmission curve are able to recover from polarization after less then 4 hours sun exposure. The plot shows that the solar cell modules with encapsulant that has increased UV transmission have a faster recovery rate from polarization during sun exposure than encapsulant without increased UV transmission (see 621).

Solar cell polarization can be further prevented by increasing the volume specific resistance of the encapsulant 203 to at least 5x10¹³ Ohm-cm (measured as per the ASTM standard D257 for measuring resistivity) in the normal operating temperature range of -40°C to 90°C. The increased volume specific resistance together with the wide UV transmission curve advantageously allow for a module level solution to solar cell polarization.

Preferably, the encapsulant 203 has a transmission curve that allows light having a wavelength less than 350nm. FIG. 4 shows the transmission curve of the encapsulant 203 in accordance with an embodiment of the present invention. FIG. 4 also shows the transmission curve of glass used as a transparent cover 201 and EVA. In the example of FIG. 4, the encapsulant 203 has a UV transmission curve that starts at 280nm. That is, the encapsulant 203 of FIG. 4 allows light having a wavelength of 280nm and longer to pass through; light having shorter wavelengths is blocked. The encapsulant 203 thus allows more UV light to pass through compared to EVA.

In one embodiment, the encapsulant 203 comprises an encapsulant having a UV transmission curve that allows UV light having a wavelength shorter than 350nm to pass through and having a volume specific resistance higher than 5x10¹³ Ohm-cm over the temperature range -40°C to 90°C measured using the ASTM standard D257 for measuring resistivity.

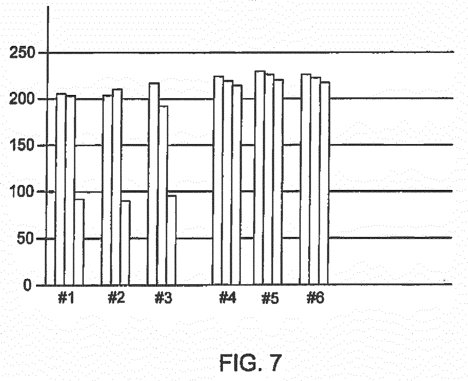

FIG. 7 shows test results comparing solar cell modules with an EVA encapsulant (samples #1, #2, and #3) to solar cell modules with an encapsulant that has wide UV transmission curve and high volume specific resistance (sample #4, #5, and #6). All of the solar cell modules in the test comprise back junction solar cells from Sunpower Corporation. The vertical axis represents normalized power output of the solar cell modules. Three measurements were done for each solar cell module sample. The graphs from left to right represent measurements taken on different days, with the leftmost graph being on the first day of the test, the middle graph being on the fourth day, and the rightmost graph being on the thirteenth day. Note that the power outputs of samples #1, #2, and #3 have degraded on the thirteenth day compared to those of samples #4, #5, and #6, evidencing the advantageous effect of an encapsulant with wide UV transmission curve and high volume specific resistance.

The UV-optimized encapsulant 203 allows for prevention of polarization without having to make changes to the solar cells 101 or changing the electrical configuration, such as grounding, of the solar cell module 100. The module-level solution as described herein can thus be readily implemented in currently available or new design solar cell modules.

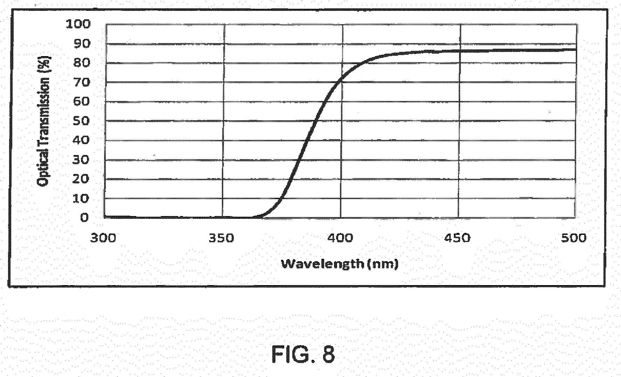

In light of the present disclosure, one of ordinary skill in the art will appreciate that the transparent top cover and the encapsulant on the front portion of the solar cell module may be treated collectively as a front protection package having a combined UV transmission curve and volume specific resistance. For example, the transparent top cover 201 and the encapsulant 203 on the front side of the solar cells 101, together, may have a combined UV transmission curve shown in FIG. 8 and a volume specific resistance of at least 5x10¹³ Ohm-cm as measured using the ASTM standard D257 for measuring resistivity. In the example of FIG. 8, the encapsulant 203 on the front side of the solar cells 101 has a thickness of about 450µm, plus or minus 50µm. In the example of FIG. 8, the transparent top cover 201 and the encapsulant 203 on the front side of the solar cells 101 has a stop band at less than 350nm wavelength (1% transmission).

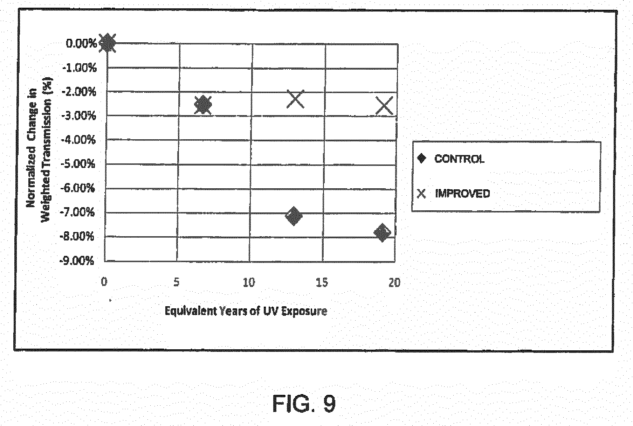

FIGS. 9-11 show plots of test data comparing solar cell modules with a front protection package in accordance with an embodiment of the present invention (labeled as "improved") and solar cell modules with glass transparent cover and EVA encapsulant (labeled as "control'). The solar cells in the improved and control solar cell modules are back junction solar cells from Sunpower Corporation. In FIGS. 9-11, the top protection package of the improved solar cell modules has a UV transmission curve that allows light having a wavelength shorter than 350nm, has a volume specific resistance greater than 5x10¹³ Ohm-cm (measured as per the ASTM standard D257 for measuring resistivity), and an encapsulant on the front side of the solar cells having a thickness of about 450µm on the front side, plus or minus 50µm.

In FIG. 9, the vertical axis represents normalized change in weighted transmission, and the horizontal axis represents equivalent years of UV exposure. Weighted transmission is defined as the net encapsulant transmission weighted at each wavelength by the solar AM 1.5G spectrum and the solar cell quantum efficiency. The "X" plots are for the improved solar cell modules and the diamond plots are for the control solar cell modules. The improved solar cell modules show a less significant drop in transmission compared to the control solar cell modules.

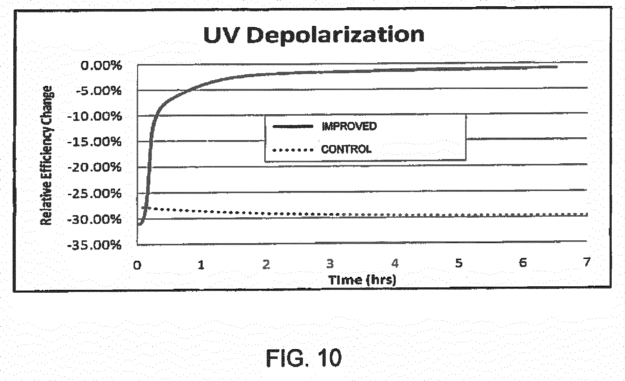

FIG. 10 shows how fast the improved solar cell modules recover their efficiency from a degraded or polarized state compared to the control solar cell modules. In FIG. 10, the vertical axis represents relative efficiency change and the horizontal axis represents time in hours. The solid plot is for the improved solar cell modules and the dotted plot is for the control solar cell modules. Note that the improved solar cell modules recover within an hour while the control solar cell modules remain in polarized state even after seven hours.

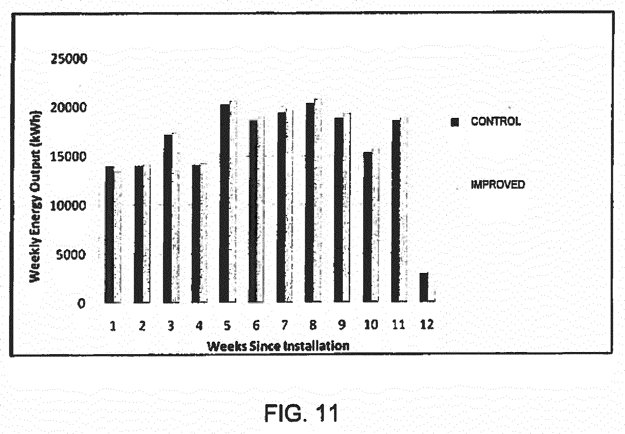

FIG. 11 shows the energy output of the improved solar cell modules and the control solar cell modules in the field in a twelve week period. In FIG. 11, the vertical axis represents weekly energy output (in kWh) and the horizontal axis represents weeks since installation. The dark bars are for the control solar cell modules and the light bars are for the improved solar cell modules. As evidenced in FIG. 11, in terms of energy output, the improved solar cell modules have equivalent or better performance compared to the control solar cell modules. The module level solutions presented herein thus prevent or minimize the effects of polarization without adversely affecting energy output.

While specific embodiments of the present invention have been provided, it is to be understood that these embodiments are for illustration purposes and not limiting. Many additional embodiments will be apparent to persons of ordinary skill in the art reading this disclosure.

## Claims

1. A solar cell module comprising:
a plurality of interconnected solar cells (101), each of the solar cells comprising back junction solar cells having a front side that faces the sun during normal operation and a backside opposite the front side;
a transparent (201) cover over the front sides of the solar cells;
a backsheet (205) on the backsides of the solar cells; and
**characterized in that**
an encapsulant (203) protectively bonding the solar cells and the backsheet (205), the encapsulant (203) and the transparent cover (201) collectively having a UV transmission curve with a stop band at less than 350nm wavelength and a volume specific resistance of at least 5x10¹³ Ωcm,
the encapsulant (203) has the UV transmission curve that starts at 280nm.

2. The solar cell module of claim 1, wherein the collective UV transmission curve of the encapsulant (203) and the transparent cover (201) allows UV light having a wavelength of 350nm and less to pass through.

3. The solar cell module of claim 1, wherein the transparent cover (201) comprises glass.

4. The solar cell module of claim 1, wherein the backsheet (205) comprises TPE layers: Tedlar/Polyester/EVA.

5. The solar cell module of claim 1, wherein the encapsulant (203) has the volume specific resistance of at least 5x10¹³ Ωcm in the temperature range -40°C to 90°C.

6. The solar cell module of claim 1, wherein the transparent cover (201) is the topmost layer on the front side.

7. The solar cell module of claim 1, wherein the encapsulant (203) on the front side of the solar cells (101) has a thickness within the range of 400µm and 500µm.

## Patentansprüche

1. Solarzellenmodul, umfassend:
eine Mehrzahl von miteinander verbundenen Solarzellen (101), wobei jede der Solarzellen Solarzellen mit rückseitigem Kontakt umfasst, die eine Vorderseite, die der Sonne während des normalen Betriebs zugewandt ist, und eine Rückseite, die der Vorderseite gegenüberliegt, aufweisen;
eine transparente Abdeckung (201) über der Vorderseite der Solarzellen;
eine Rückschicht (205) auf den Rückseiten der Solarzellen; und
**dadurch gekennzeichnet, dass**
eine Verkapselung (203) die Solarzellen und die Rückschicht (205) schützend verbindet, wobei die Verkapselung (203) und die transparente Abdeckung (201) gemeinsam eine UV-Übertragungskurve mit einem Sperrbereich bei einer Wellenlänge von weniger als 350 nm und einen volumenspezifischen Widerstand von mindestens 5x10¹³ Ωcm aufweisen,
die Verkapselung (203) die UV-Übertragungskurve aufweist, die bei 280 nm beginnt.

2. Solarzellenmodul nach Anspruch 1, wobei die kombinierte UV-Übertragungskurve der Verkapselung (203) und die transparente Abdeckung (201) UV-Licht mit einer Wellenlänge von 350 nm oder weniger durchlassen.

3. Solarzellenmodul nach Anspruch 1, wobei die transparente Abdeckung (201) Glas umfasst.

4. Solarzellenmodul nach Anspruch 1, wobei die Rückschicht (205) TPE-Schichten umfasst: Tedlar/Polyester/EVA.

5. Solarzellenmodul nach Anspruch 1, wobei die Verkapselung (203) einen volumenspezifischen Widerstand von mindestens 5x10¹³ Ωcm im Temperaturbereich von - 40 °C bis 90 °C aufweist.

6. Solarzellenmodul nach Anspruch 1, wobei die transparente Abdeckung (201) die oberste Schicht auf der Vorderseite ist.

7. Solarzellenmodul nach Anspruch 1, wobei die Verkapselung (203) auf der Vorderseite der Solarzellen (101) eine Dicke im Bereich von 400 µm und 500 µm aufweist.

## Revendications

1. Module de cellules solaires comprenant :
une pluralité de cellules solaires interconnectées (101), chacune des cellules solaires comprenant des cellules solaires à jonction arrière ayant une face avant qui fait face au soleil en fonctionnement normal et une face arrière opposée à la face avant ;
un couvercle transparent (201) sur les côtés avant des cellules solaires ;
une feuille arrière (205) sur les côtés arrière des cellules solaires ; et
**caractérisé en ce que**
un encapsulant (203) liant de manière protectrice les cellules solaires et la feuille arrière (205), l'encapsulant (203) et le couvercle transparent (201) présentant collectivement une courbe de transmission UV avec une bande d'arrêt à une longueur d'onde inférieure à 350 nm et une résistance spécifique au volume d'au moins 5x10¹³ Ωcm,
l'encapsulant (203) a une courbe de transmission UV qui commence à 280 nm.

2. Module de cellules solaires selon la revendication 1, dans lequel la courbe de transmission UV collective de l'encapsulant (203) et du couvercle transparent (201) laisse passer une lumière UV ayant une longueur d'onde de 350 nm et moins.

3. Module de cellules solaires selon la revendication 1, dans lequel le couvercle transparent (201) comprend du verre.

4. Module de cellules solaires selon la revendication 1, dans lequel la feuille arrière (205) comprend des couches de TPE : Tedlar/Polyester/EVA.

5. Module de cellules solaires selon la revendication 1, dans lequel l'encapsulant (203) a une résistance spécifique au volume d'au moins 5x10¹³ Ωcm dans la plage de températures allant de -40 °C à 90 °C.

6. Module de cellules solaires selon la revendication 1, dans lequel le couvercle transparent (201) est la couche la plus sur le dessus sur le côté avant.

7. Module de cellules solaires selon la revendication 1, dans lequel l'encapsulant (203) sur le côté avant des cellules solaires (101) a une épaisseur comprise dans la plage de 400 µm et 500 µm.
